# FASCICULE DE BREVET EUROPEEN

(11) **EP 1 419 506 B1**
(45) Date de publication et mention de la délivrance du brevet: **16.03.2005**
(21) Numéro de dépôt: 02796289.3
(22) Date de dépôt: 26.07.2002
(51) Int. Cl.: G11C 11/16, H01F 10/32

(54) **DISPOSITIF DE COMMANDE DE RENVERSEMENT DE SENS D'AIMENTATION SANSCHAMP MAGNETIQUE EXTERNE**
STEUEREINRICHTUNG ZUR UMKEHR DER MAGNETISIERUNGSRICHTUNG OHNE EIN EXTERNES MAGNETFELD
CONTROL DEVICE FOR REVERSING THE DIRECTION OF MAGNETISATION WITHOUT AN EXTERNAL MAGNETIC FIELD

(30) Priorité: 27.07.2001 FR 0110126
(43) Date de publication de la demande: 19.05.2004
(73) Titulaire: Thales, 75008 Paris (FR)
(72) Inventeur: NGUYEN VAN DAU, Frédéric THALES Intellectual Prop., F-94117 Arcueil (FR); CROS, Vincent THALES Intellectual Property, F-94117 Arcueil Cedex (FR); GEORGE, Jean-Marie THALES Intellectual Property, F-94117 Arcueil Cedex (FR); GROLLIER, Julie THALES Intellectual Property, F-94117 Arcueil Cedex (FR); JAFFRES, Henri THALES Intellectual Property, F-94117 Arcueil Cedex (FR); PETROFF, Frédéric THALES Intellectual Property, F-94117 Arcueil Cedex (FR)
(74) Mandataire: Chaverneff, Vladimir
(86) Numéro de dépôt international: PCT/FR2002/002684
(87) Numéro de publication internationale: WO 2003/019568

(56) Documents cités:
- EP-A- 1 096 500
- US-A- 5 541 868
- US-A- 5 661 062

## Description

La présente invention se rapporte à un dispositif de commande de renversement de sens d'aimantation sans champ magnétique externe.

On connaît d'après le brevet US 5 695 864 un composant électronique à cinq couches, dont certaines sont magnétiques et d'autres qui ne le sont pas, permettant la commutation magnétique, c'est-à-dire l'écriture, d'éléments magnétiques de mémoire. Ce composant électronique met à profit le phénomène selon lequel il est possible d'induire le renversement d'aimantation d'un film ferromagnétique par application d'un courant électrique polarisé en spin sans avoir à appliquer un champ magnétique externe aux éléments magnétiques.

L'utilisation des dispositifs tels que les mémoires dites « MRAM » (« Magnetic Random Access Memory» ) nécessite l'utilisation d'une commande magnétique locale pour réaliser leur commutation magnétique (écriture ou ré-écriture de la mémoire). Actuellement, pour réaliser cette commutation, on utilise le champ magnétique produit par un courant électrique appliqué à une lame conductrice (appelée « word line ») qui est en contact direct avec les éléments magnétiques. Or, dans la course à la miniaturisation, cette solution ne convient plus pour obtenir un champ magnétique suffisamment intense pour assurer la commutation, car, soit l'encombrement des « word line », soit la densité de courant à leur appliquer seraient trop importants, et un trop fort courant pourrait détruire ces éléments. Pour y remédier, on pourrait être amené à essayer de mettre en oeuvre le dispositif décrit dans le susdit brevet US. Cependant, un tel dispositif serait difficilement réalisable, en particulier du fait que l'évacuation du courant de commande, nécessairement important, se fait au détriment de l'efficacité de la commande magnétique.

La présente invention a pour objet un dispositif de commande de renversement d'aimantation sans champ magnétique externe, dispositif qui puisse être miniaturisé (à des dimensions sub-microniques), qui ait une efficacité la plus élevée possible, et qui ne risque pas d'endommager les éléments qu'il commande.

Le dispositif de commande conforme à l'invention comporte, entre deux électrodes planes, un élément de commande magnétique comprenant, à partir de la première électrode, une couche ferromagnétique, une couche non magnétique, une deuxième couche ferromagnétique et une deuxième électrode, l'épaisseur de la deuxième couche ferromagnétique étant inférieure à celle de la première, l'épaisseur de la deuxième électrode étant suffisamment faible pour permettre un couplage magnétique entre la deuxième couche ferromagnétique et l'élément commandé par ce dispositif de commande.

La présente invention sera mieux comprise à la lecture de la description détaillée de deux modes de réalisation, pris à titre d'exemples non limitatifs et illustrés par le dessin annexé, sur lequel :
- la figure 1 est une vue schématique en coupe d'un premier mode de réalisation du dispositif de commande de l'invention;
- la figure 2 est une vue schématique en coupe d'un deuxième mode de réalisation du dispositif de commande de l'invention; et
- la figure 3 est une vue schématique en coupe du dispositif de commande de l'invention associé à un élément de mémoire magnétique MRAM.

La présente invention est décrite ci-dessous en référence à la commande d'un élément de mémoire magnétique pour y inscrire (ou réinscrire) une information binaire, mais il est bien entendu que l'invention n'est pas limitée à cette seule application, et qu'elle peut être mise en oeuvre pour la commande magnétique de divers dispositifs ferromagnétiques, pour en renverser le sens d'aimantation : ensemble d'éléments MRAM (commandés par un ensemble de. dispositifs de commande), support magnétique en déplacement relatif par rapport à un dispositif de commande pour en commander le renversement de sites magnétiques distincts, etc...

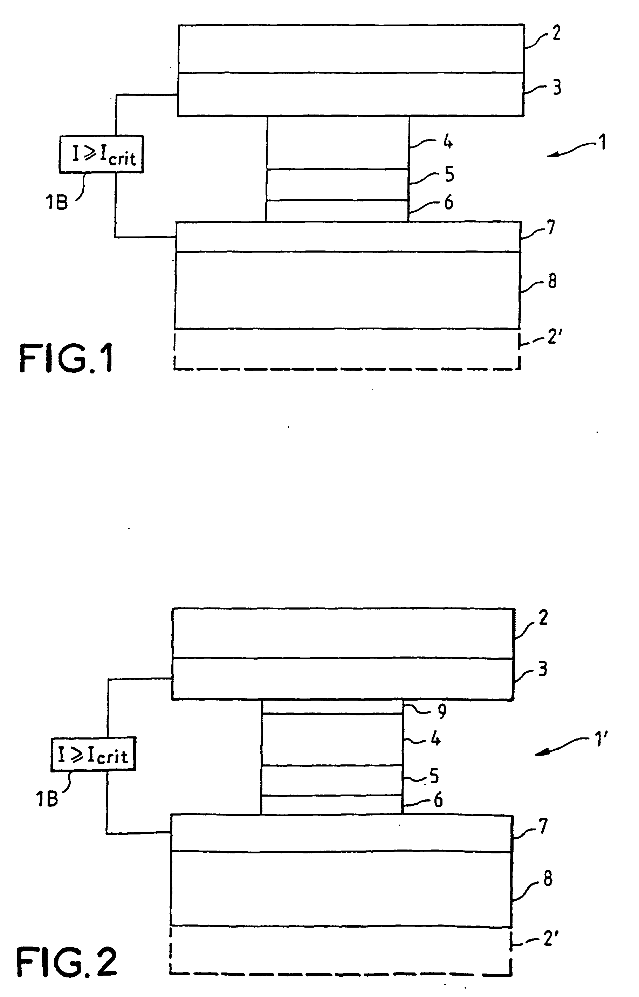

Le dispositif de commande 1 schématiquement représenté en figure 1 comporte plusieurs couches formées successivement sur un substrat 2 (par exemple en Silicium). Ces couches sont, dans l'ordre : une première électrode 3, une première couche ferromagnétique 4, une couche conductrice non magnétique 5, une deuxième couche ferromagnétique 6 et une électrode 7. Le dispositif commandé 8 est au contact de l'électrode 7 (ou, en variante à une très faible distance de celle-ci, de telle façon que la somme des épaisseurs de l'électrode 7 et de la couche d'air entre cette électrode et le dispositif 8 soit inférieure à une valeur déterminée E qui correspond à la distance limite entre la couche 6 et le dispositif 8, valeur au-delà de laquelle le dispositif de commande ne peut plus induire le retournement de l'aimantation du dispositif 8).

Un courant de commande Ic, supérieur ou égal à une valeur I_{crit} (valeur critique à partir de laquelle se produit le renversement d'aimantation du dispositif 8) est fourni par une source de courant 1B.

Selon un exemple typique de réalisation, les électrodes 3 et 7 sont en matériau très bon conducteur électrique tel que Au, Cu, Al. L'épaisseur de l'électrode 3 n'est pas critique, sa valeur est une valeur typique des électrodes conductrices de dispositifs équivalents. Selon un exemple de réalisation, elle est d'environ 1000 Å. L'épaisseur de l'électrode 7 est comprise entre 5 et 10 000 Å environ en fonction du mécanisme de couplage magnétique avec le dispositif 8 mis en oeuvre. La couche ferromagnétique 4 est en matériau présentant de bonnes qualités ferromagnétiques, tel que Fe, Co, Ni ou en alliage composé à partir de ces éléments, ou bien même un matériau demi-métallique (oxydes magnétiques, alliages Heussler, ...). L'épaisseur de cette couche 4 est, dans un exemple de réalisation, comprise entre quelques dizaines et quelques centaines de nm, suivant sa composition. La couche 5 est en matériau conducteur non ferromagnétique, et son épaisseur est de quelques nm. La couche 6 a la même composition ferromagnétique que la couche 4, mais son épaisseur est inférieure à celle de la couche 4, par exemple quelques dizaines de pourcents de l'épaisseur de la couche 4.

Le fonctionnement du dispositif de commande décrit ci-dessus est le suivant. D'après le susdit brevet US, on connaît un dispositif de commande de renversement de sens d'aimantation dans une mémoire « MRAM », présentant les inconvénients cités ci-dessus. Le dispositif de commande de l'invention permet, grâce à son architecture, et en particulier grâce à la disposition de la deuxième électrode 7 de découpler la partie écriture du dispositif 8 (qui est dans ce cas une mémoire MRAM) de la partie lecture, ce qui s'explique ainsi.

Il prévaut actuellement deux théories expliquant le phénomène de renversement d'aimantation (c'est-à-dire rotation de 180° du sens d'aimantation) par injection d'un courant polarisé en spin. La première, proposée par J. SLONCZEWSKI dans le susdit brevet US, est basée sur le principe de conservation du moment cinétique associé au moment magnétique. Elle s'appuie sur un système magnétique tricouche comportant une couche non ferromagnétique entre deux couches ferromagnétiques. L'injection d'un courant de la première couche ferromagnétique vers la couche non ferromagnétique donne naissance à un courant polarisé en spin auquel on peut associer un flux de moment magnétique S. Pour un courant de forte densité, la relaxation de la composante transverse du moment magnétique transporté par le flux S induit un couple sur l'aimantation de la couche 6, ce couple pouvant, dans certains cas (courant supérieur à une valeur critique), induire le renversement de l'aimantation de la deuxième couche ferromagnétique.

Selon la deuxième théorie, l'injection d'un courant polarisé en spin donne naissance à des effets d'accumulation de spin aux interfaces de la couche non ferromagnétique. Ces effets sont bien connus pour être à l'origine de la magnéto-résistance géante (« GMR ») en géométrie perpendiculaire (voir par exemple l'article de T. VALET et A. FERT dans Physical Review, B, 48, 7099 de 1993). L'amplitude du moment magnétique induit par l'accumulation de spin dépend de la balance entre injection et relaxation de spin (retour à l'état d'énergie minimale du système) et également de l'orientation relative des aimantations des deux couches ferromagnétiques. On peut montrer que pour des densités de courant suffisamment importantes, l'état d'énergie du système le plus favorable est celui pour lequel l'aimantation de la deuxième couche ferromagnétique s'est renversée afin d'obtenir une configuration magnétique relative des deux couches ferromagnétiques inverse de celle existant à faible courant.

Quelle que soit l'explication théorique exacte, deux conclusions importantes s'imposent :
a) la densité de courant traversant le système tricouche et nécessaire pour renverser l'aimantation de la deuxième couche ferromagnétique est, en l'état actuel des expériences, de l'ordre de 10¹¹A/m². Une valeur si élevée par rapport à celles utilisées dans les dispositifs d'électronique de spin usuels impose que les systèmes en question soient entièrement métalliques et de taille submicronique,
b) la meilleure efficacité de renversement s'obtient lorsque le courant polarisé en spin est injecté perpendiculairement aux plans des couches.

Le dispositif de l'invention décrit ci-dessus satisfait ces deux conditions, et son fonctionnement est le suivant. La couche ferromagnétique 4 permet de polariser en spin le courant provenant de la source 1 B via l'électrode 3 et arrivant pratiquement perpendiculairement aux plans des couches du dispositif 1. Ce courant ainsi polarisé traverse la couche ferromagnétique 6 pour parvenir à l'électrode 7 (toujours perpendiculairement aux plans des couches) et revenir à la source 1 B. Le renversement de l'aimantation de la couche 6 est ainsi assuré lorsque la densité de courant atteint la valeur critique mentionnée ci-dessus (environ 10¹¹A/m²). Ce renversement de sens d'aimantation permet de commander celui du dispositif 8. Bien entendu, ce processus est réversible si on change le sens du courant.

Le mode de réalisation 1' de la figure 2 reprend les éléments essentiels du dispositif 1 de la figure 1, à savoir les éléments 2 à 7, disposés dans le même ordre et qui peuvent être de même composition et de mêmes dimensions qu'en figure 1, la différence résidant dans le fait que l'on interpose une couche antiferromagnétique 9 entre les couches 3 et 4. Cette couche 9 est, par exemple en IrMn, NiMn, PtMn ou FeMn et son épaisseur est de quelques nm. La couche 9 permet de fixer de façon connue en soi l'orientation de l'aimantation de la couche 4, en plus de la possibilité offerte par l'optimisation des paramètres de la couche 4 (composition et/ou épaisseur).

On notera que pour le mode de réalisation de la figure 1, comme pour celui de la figure 2, l'épaisseur de la couche 5 est choisie de manière à optimiser le courant polarisé en spin arrivant à la couche 6 et à minimiser l'ensemble des couplages entre les couches 4 et 6. Bien entendu, pour que la densité très élevée du courant nécessaire au renversement de sens d'aimantation ne détruise pas le dispositif de commande de l'invention, il faut que la section des différentes couches 4 à 6 soit de taille submicronique, avantageusement, cette section est inférieure à 0,5 µm².

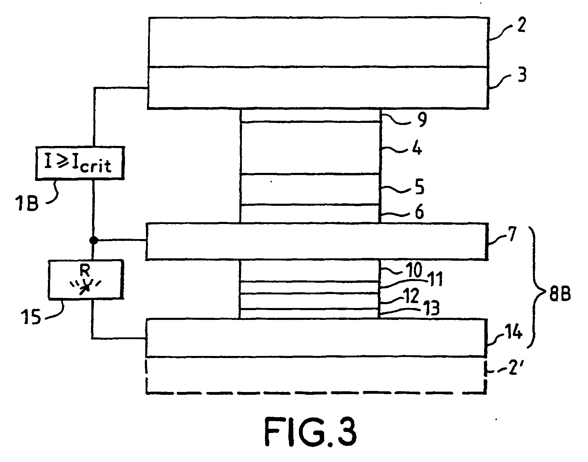

On a représenté en figure 3 le dispositif de la figure 2 dans lequel le dispositif 8 est un élément 8B de mémoire magnétique de type MRAM. Cet élément 8A comporte plusieurs couches formées sur l'électrode 7, et qui sont, dans l'ordre : une couche ferromagnétique 10, une couche non magnétique 11, une deuxième couche ferromagnétique 12, une couche antiferromagnétique 13 et une électrode 14.

L'élément 8B est réalisé de façon connue en soi. On précisera seulement que les couches ferromagnétiques peuvent avoir la même composition que celles du dispositif de commande des figures 1 et 2, et que la couche non magnétique 11 peut être soit en métal utilisé habituellement pour les mémoires utilisant l'effet de magnétorésistance géante (« GMR »), soit en matériau isolant ou semiconducteur habituellement utilisé pour les mémoires mettant en oeuvre l'effet de magnétorésistance tunnel (« TMR »). La couche 13, qui est optionnelle, permet avantageusement de rendre « dure » la couche ferromagnétique 12, grâce à un effet de couplage d'échange en « retenant » l'aimantation de la couche 12 dans une direction donnée. L'état de résistance électrique de la mémoire (haut ou bas, avec une différence d'environ 10 à 50 % de valeur de résistance entre ces deux états) est donc uniquement déterminé par l'orientation de l'aimantation dans la couche ferromagnétique « mobile » 10 par rapport à celle de la couche « fixe » 12. Afin de déterminer l'état de la mémoire magnétique 8B, on mesure la résistance des couches comprises entre les électrodes 7 et 14 à l'aide d'un appareil de mesure de résistance approprié 15 branché à ces électrodes, ou bien entre les électrodes 3 et 14.

Dans le dispositif de l'invention, une des caractéristiques importantes est la présence de l'électrode 7, qui est formée par une couche de matériau conducteur non magnétique. D'une part, cette couche 7 permet de séparer électriquement l'élément de commande du dispositif commandé (8, 8A). D'autre part, elle permet d'évacuer les courants intenses qu'il est nécessaire de faire passer dans le dispositif de commande magnétique sans qu'ils passent par le dispositif commandé (élément de mémoire magnétique). Enfin, elle permet de faire circuler les courants dans le dispositif de commande et dans le dispositif commandé perpendiculairement aux plans des couches.

Deux processus de couplage magnétique induit par la couche ferromagnétique 6, au travers de l'électrode 7, dans la couche ferromagnétique à commander du dispositif 8 (couche 10 dans le cas de l'élément de mémoire de la figure 3) permettent de commander l'orientation magnétique dans cette couche sans appliquer de champ magnétique externe. Le premier processus repose sur l'existence d'un couplage d'échange magnétique indirect entre la couche 6 et la couche 10 au travers de l'électrode 7. Ce phénomène a été largement étudié dans les systèmes multicouches magnétiques. Il est connu que ce couplage d'échange persiste même pour des épaisseurs de couche séparatrice (électrode 7 en l'occurrence) allant jusqu'à 100 Å, et que son signe (couplage parallèle ou antiparallèle) dépend de l'épaisseur de cette couche séparatrice.

Un deuxième processus possible est le couplage dipolaire magnétique. En effet, ce type de couplage, qui persiste même pour des distances (épaisseur de la couche 7, ici) de quelques centaines de nm oriente antiparallèlement les aimantations des couches 6 et 10. Le renversement du sens d'aimantation de la couche libre 6 par injection d'un courant polarisé en spin dans le dispositif de commande provoque à son tour le renversement de l'aimantation de la couche mobile (couche 10 de l'élément de mémoire). Il est ainsi possible de contrôler l'état magnétique d'un élément de mémoire, et donc d'écrire dans cet élément de mémoire sans lui appliquer de champ magnétique externe.

Enfin, il est à noter que la valeur du courant critique à partir de laquelle se produit le renversement d'aimantation de la couche 6 et donc de la couche 10 est, en première approximation, inversement proportionnelle au carré de la surface de cette couche. Il en résulte que l'efficacité du dispositif de commande de l'invention augmente lorsque diminue la taille de l'élément de mémoire commandé, contrairement à ce qui est actuellement le cas des dispositifs connus qui utilisent une commande magnétique par un champ magnétique, lui-même généré par un courant, la densité de courant devant être de plus en plus élevé lorsque la taille de l'élément de mémoire diminue. On lève ainsi un obstacle à la miniaturisation de l'élément de mémoire.

Selon une variante de l'invention, représentée en traits interrompus sur les figures, le substrat (2) au lieu d'être le support de l'électrode 3, est le support du dispositif 8 ou 8B (si ce dispositif est fixe par rapport au dispositif de commande, qui est formé sur lui). Ce substrat est alors référencé 2'.

## Revendications

1. Dispositif de commande de renversement de sens d'aimantation sans champ magnétique externe, **caractérisé par le fait qu'**il comporte, entre deux électrodes planes (3, 7) un élément de commande magnétique comprenant, à partir de la première électrode (3), une première couche ferromagnétique (4), une couche non magnétique (5), une deuxième couche ferromagnétique (6) et une deuxième électrode (7), l'épaisseur de la deuxième couche ferromagnétique étant inférieure à celle de la première, l'épaisseur de la deuxième électrode (7) étant suffisamment faible pour permettre un couplage magnétique entre la deuxième couche ferromagnétique et l'élément commandé (8, 8B) par ce dispositif de commande.

2. Dispositif selon la revendication 1, **caractérisé par le fait que** l'épaisseur de la deuxième électrode, y compris un éventuel entrefer existant entre cette électrode et l'élément ferromagnétique commandé, est comprise entre 5 et 10 000 Å environ.

3. Dispositif selon la revendication 1 ou 2, **caractérisé par le fait que** la première couche ferromagnétique a une épaisseur comprise entre quelques dizaines et quelques centaines de nm, que la couche non magnétique a une épaisseur de quelques nm et que la deuxième couche ferromagnétique a une épaisseur inférieure de quelques dizaines de pourcents à celle de la première couche ferromagnétique.

4. Dispositif selon l'une des revendications précédentes, **caractérisé par le fait qu'**il comporte entre la première couche ferromagnétique et la - première électrode une couche antiferromagnétique (9).

5. Dispositif selon la revendication 4, **caractérisé par le fait que** la couche antiferromagnétique a une épaisseur de quelques nm.

6. Dispositif selon l'une des revendications précédentes, **caractérisé par le fait que** le dispositif qu'il commande est un élément de mémoire magnétique (8B) formé sur la deuxième électrode.

7. Dispositif selon la revendication 6, **caractérisé par le fait que** l'élément de mémoire magnétique comporte une première couche ferromagnétique (10), une couche non magnétique (11), une deuxième couche ferromagnétique (12) et une électrode (14).

8. Dispositif selon la revendication 7, **caractérisé par le fait que** l'élément de mémoire magnétique comporte une couche antiferromagnétique (13) entre sa deuxième couche ferromagnétique (12) et son électrode (14).

9. Dispositif selon l'une des revendications précédentes, **caractérisé par le fait que** le dispositif commandé (8, 8B) est en mouvement relatif par rapport au dispositif de commande.

## Patentansprüche

1. Vorrichtung zur Steuerung der Umkehr der Magnetisierungsrichtung ohne äußeres Magnetfeld, **dadurch gekennzeichnet, dass** sie zwischen zwei flachen Elektroden (3, 7) ein magnetisches Steuerungselement aufweist, das ausgehend von der ersten Elektrode (3) eine erste ferromagnetische Schicht (4), eine nicht magnetische Schicht (5), eine zweite ferromagnetische Schicht (6) und eine zweite Elektrode (7) aufweist, wobei die Dicke der zweiten ferromagnetischen Schicht geringer ist als die der ersten, wobei die Dicke der zweiten Elektrode (7) gering genug ist, um eine magnetische Kopplung zwischen der zweiten ferromagnetischen Schicht und dem von dieser Steuervorrichtung gesteuerten Element (8, 8B) zu ermöglichen.

2. Vorrichtung nach Anspruch 1, **dadurch gekennzeichnet, dass** die Dicke der zweiten Elektrode, einschließlich eines möglichen Magnetspalts, der zwischen dieser Elektrode und dem gesteuerten ferromagnetischen Element vorhanden ist, zwischen etwa 5 und 10 000 Å liegt.

3. Vorrichtung nach Anspruch 1 oder 2, **dadurch gekennzeichnet, dass** die erste ferromagnetische Schicht eine Dicke aufweist, die zwischen einigen Zehn und einigen Hundert nm liegt, dass die nicht magnetische Schicht eine Dicke von einigen nm aufweist, und dass die zweite ferromagnetische Schicht eine um einige zehn Prozent geringere Dicke als die der ersten ferromagnetischen Schicht aufweist.

4. Vorrichtung nach einem der vorhergehenden Ansprüche, **dadurch gekennzeichnet, dass** sie zwischen der ersten ferromagnetischen Schicht und der ersten Elektrode eine antiferromagnetische Schicht (9) aufweist.

5. Vorrichtung nach Anspruch 4, **dadurch gekennzeichnet, dass** die antiferromagnetische Schicht eine Dicke von einigen nm aufweist.

6. Vorrichtung nach einem der vorhergehenden Ansprüche, **dadurch gekennzeichnet, dass** die von ihr gesteuerte Vorrichtung ein Element eines Magnetspeichers (8B) ist, das auf der zweiten Elektrode ausgebildet ist.

7. Vorrichtung nach Anspruch 6, **dadurch gekennzeichnet, dass** das Magnetspeicherelement eine erste ferromagnetische Schicht (10), eine nicht magnetische Schicht (11), eine zweite ferromagnetische Schicht (12) und eine Elektrode (14) aufweist.

8. Vorrichtung nach Anspruch 7, **dadurch gekennzeichnet, dass** das Magnetspeicherelement eine antiferromagnetische Schicht (13) zwischen seiner zweiten ferromagnetischen Schicht (12) und seiner Elektrode (14) aufweist.

9. Vorrichtung nach einem der vorhergehenden Ansprüche, **dadurch gekennzeichnet, dass** die gesteuerte Vorrichtung (8, 8B) sich bezüglich der Steuervorrichtung in relativer Bewegung befindet.

## Claims

1. Device for controlling the reversal of direction of magnetization with no external magnetic field, **characterized in that** it includes, between two flat electrodes (3, 7), a magnetic control element, comprising, from the first electrode (3), a first ferromagnetic layer (4), a non-magnetic layer (5), a second ferromagnetic layer (6) and a second electrode (7), the thickness of the second ferromagnetic layer being less than that of the first, the thickness of the second electrode (7) being sufficiently small to allow magnetic coupling between the second ferromagnetic layer and the element controlled (8, 8B) by this control device.

2. Device according to Claim 1, **characterized in that** the thickness of the second electrode, including any air gap existing between this electrode and the controlled ferromagnetic element, is between approximately 5 and 10 000 Å.

3. Device according to Claim 1 or 2, **characterized in that** the first ferromagnetic layer has a thickness between a few tens and a few hundreds of nm, **in that** the non-magnetic layer has a thickness of a few nm and **in that** the second ferromagnetic layer has a thickness a few tens of percents less than that of the first ferromagnetic layer.

4. Device according to one of the preceding claims, **characterized in that** it comprises, between the first ferromagnetic layer and the first electrode, an antiferromagnetic layer (9).

5. Device according to Claim 4, **characterized in that** the antiferromagnetic layer has a thickness of a few nm.

6. Device according to one of the preceding claims, **characterized in that** the device that it controls is a magnetic memory element (8B) formed on the second electrode.

7. Device according to Claim 6, **characterized in that** the magnetic memory element comprises a first ferromagnetic layer (10), a non-magnetic layer (11), a second ferromagnetic layer (12) and an electrode (14).

8. Device according to Claim 7, **characterized in that** the magnetic memory element comprises an antiferromagnetic layer (13) between its second ferromagnetic layer (12) and its electrode (14).

9. Device according to one of the preceding claims, **characterized in that** the controlled device (8, 8B) is in relative motion relative to the control device.
